# EUROPEAN PATENT APPLICATION

(11) **EP 2 172 967 A1**
(43) Date of publication of application: **07.04.2010**
(21) Application number: 09009498.8
(22) Date of filing: 22.07.2009
(51) Int. Cl.: H01L 21/265

(54) **Method for manufacturing silicon carbide**

(30) Priority: 04.08.2008 JP 2008200397; 01.09.2008 JP 2008223911
(71) Applicant: Siltronic AG, 81737 München (DE)
(72) Inventor: Takayama, Seiji, 743-0011 Hikari Yamaguchi (JP); Ikari, Atsushi, Dr., 745-0851 Shunan Yamaguchi (JP); Murphy, Brian, 84347 Pfarrkirchen (DE)
(74) Representative: Baar, Christian

(57) **Abstract**

The invention relates to a method of manufacturing silicon carbide, wherein a silicon oxide layer 2 is formed on the surface of a silicon substrate 1; carbon ions are implanted into the silicon substrate 1 through the silicon oxide layer 2, thereby forming a carbon containing layer 3 in which silicon and carbon are mixed; the silicon oxide layer 2 is selectively removed from the silicon substrate 1, thereby exposing the carbon containing layer 3; the silicon substrate 1 is subjected to thermal treatment, and the carbon containing layer 3 is crystallized into a single crystal, thereby forming a single-crystal silicon carbide layer 4; and an oxide layer 5 formed on the surface of the single-crystal silicon carbide layer 4 in the process of the thermal treatment is removed, thereby exposing the single-crystal silicon carbide layer 4; thus, a SiC wafer 10 is manufactured.

The method is capable of improving productivity compared with conventional methods without deteriorating the crystallinity of a formed silicon carbide layer.

## Description

The present invention relates to a manufacturing method of a semiconductor substrate suitable for manufacturing of a power device or optoelectronics device and, in particular, relates to a manufacturing method of silicon carbide which forms a single-crystal silicon carbide layer at a surface part of a semiconductor substrate.

Silicon carbide has a high Schottky barrier, a high breakdown field strength, and high heat conductivity in combination; therefore, silicon carbide is suitable as a material for power devices. Moreover, the lattice constant of silicon carbide is close to the lattice constant of a nitride compound semiconductor which is a typical semiconductor material for optoelectronics, and silicon carbide is capable of causing the nitride compound semiconductor to undergo epitaxial growth with low defects; therefore, silicon carbide is suitable for a material for optoelectronics devices. Under these circumstances, technical development for manufacturing a semiconductor substrate having a single-crystal silicon carbide layer at a surface part of a silicon substrate (hereinafter, referred to as "SiC wafer") has been underway (for example, see Patent Documents 1 to 8 and Non-Patent Document 1).
Patent Document 1: US2007/176210A1
Patent Document 2: JP2006-327931
Patent Document 3: US2006/267024A1
Patent Document 4: JP2005-506699
Patent Document 5: US2004/0248390A1
Patent Document 6: WO03/034485
Patent Document 7: WO03/071588
Patent Document 8: US2005/0020084A1
Patent Document 9: JP2006-528423
Patent Document 10: US7060620B2

Non-Patent Document 1: "Organometallic vapor phase epitaxial growth of GaN on a 3c-SiC/Si (111) template formed by C+-ion implantation into Si (111) subs", A. Yamamoto et al., Journal of Crystal Growth 261 (2004) 266-270,

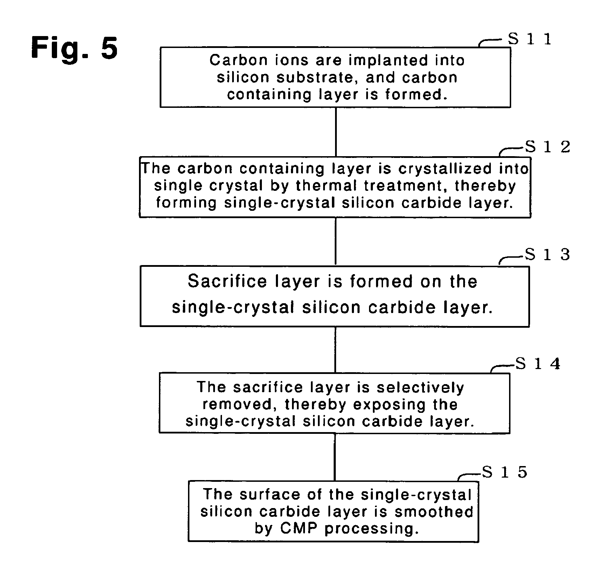

Fig. 5 shows an example of a conventional manufacturing method of a SiC wafer. This manufacturing method comprises a step (S11) of forming a carbon containing layer, in which silicon and carbon are mixed, by implanting carbon ions into a silicon substrate, a step (S12) of forming a single-crystal silicon carbide layer by annealing the silicon substrate so as to subject the carbon-containing layer to crystallization into a single crystal, a step (S13) of heating the silicon substrate in a dry oxygen atmosphere so as to form a sacrifice layer on the single-crystal silicon carbide layer, a step (S14) of exposing the single-crystal silicon carbide layer by selectively removing the sacrifice layer from the silicon substrate by etching, and a step (S15) of subjecting the surface of the exposed single-crystal silicon carbide layer to CMP (Chemical Mechanical Polishing) processing so as to smooth it.

However, in the above described conventional manufacturing method, in order to prevent deterioration of crystallinity of the silicon carbide layer, the dose amount of the implanted carbon ions has to be stoichiometric. In other words, when the dose amount of the implanted carbon ions is smaller than the stoichiometric amount (6.5×10¹⁷ to 8.0×10¹⁷/cm²) in the conventional manufacturing method, the crystallinity of the silicon carbide layer has been deteriorated. As described above, the conventional manufacturing method of the SiC wafer has not been capable of reducing the dose amount of the carbon ions to an amount less than the stoichiometric amount without deteriorating the crystallinity of the SiC wafer. Therefore, manufacturing cost cannot be reduced since the amount of used carbon ions cannot be reduced, and manufacturing time cannot be shortened since the implantation time cannot be shortened. As described above, the conventional manufacturing method has not been capable of improving the productivity of the SiC wafer by reducing the dose amount of the carbon ions without deteriorating the crystallinity of the formed silicon carbide layer.

It is an object of the invention of the present application to provide a manufacturing method of silicon carbide capable of improving productivity compared with conventional methods without deteriorating crystallinity of a formed silicon carbide layer.

In order to achieve the above described object, a manufacturing method of silicon carbide according to the present invention is characterized by comprising a step of forming a buffer layer on a surface of a silicon substrate, a step of implanting carbon ions into the silicon substrate through the buffer layer so as to form a carbon containing layer in the silicon substrate, a step of selectively removing the buffer layer from the silicon substrate so as to expose the carbon containing layer, and a step of subjecting the silicon substrate to thermal treatment so as to form a crystalline silicon carbide layer. Alternatively, the buffer layer may be removed after the thermal treatment so as to expose the crystalline silicon carbide layer. Upon the carbon ion implantation, the carbon containing layer is formed immediately below the buffer layer and the maximum value of the carbon concentration in the silicon substrate is equal to or more than 20 % and equal to and less than 49 %. In this specification, all given percentages related to carbon concentrations in the silicon substrate shall mean atomic percent. The carbon containing layer immediately below the silicon oxide layer immediately after the carbon ion implantation comprises single-crystal silicon carbide grains.

The buffer layer can be formed by a solid material like silicon oxide, silicon nitride, a mixture thereof or any other solid material having a thermal resistance equivalent to that of silicon oxide or silicon nitride that can be selectively removed from the silicon substrate.

Moreover, the manufacturing method of silicon carbide according to the present invention is preferably characterized in that the thickness of the formed buffer layer, especially in case of silicon oxide, is equal to or more than 200 nm and equal to or less than 600 nm; and the carbon ion implantation is carried out under the implantation conditions of acceleration energy of equal to or more than 100 keV and equal to or less than 200 keV and a dose amount of equal to or more than 2.5×10¹⁷/cm² and equal to or less than 6×10¹⁷/cm².

Furthermore, the manufacturing method of silicon carbide according to the present invention is preferably characterized in that the carbon ion implantation is carried out in the state that the silicon substrate is heated to a temperature of equal to or more than 400 °C and equal to or less than 1000 °C.

Moreover, the manufacturing method of silicon carbide according to the present invention is preferably characterized in that the silicon substrate is a silicon substrate manufactured by either a Czochralski method or a float zone method.

According to the present invention, a buffer layer is formed on the surface of a silicon substrate; carbon ions are implanted into the silicon substrate through the formed buffer layer, thereby forming a carbon containing layer in the silicon substrate; the buffer layer is selectively removed from the silicon substrate, thereby exposing the carbon containing layer; and, then, the silicon substrate is subjected to thermal treatment, thereby forming a crystalline silicon carbide layer. Alternatively, the buffer layer may be removed after the thermal treatment so as to expose the crystalline silicon carbide layer. Therefore, the crystallinity of the formed silicon carbide layer can be maintained even when the dose amount of the implanted carbon ions is reduced to an amount less than the stoichiometric amount. Moreover, according to the present invention, the carbon containing layer immediately below the buffer layer immediately after the carbon ion implantation comprises single-crystal silicon carbide grains. Subsequently, the buffer layer previously formed on the sample is removed. In case of silicon oxide, the layer is removed by a dilute hydrofluoric acid. However, preferably the single-crystal silicon carbide layer is directly exposed to the atmosphere during the high-temperature annealing. Consequently, defects in the single crystal are readily removed from the surface during the high-temperature annealing; therefore, the crystallinity of the silicon carbide layer can be maintained even in the state that the dose amount of the carbon ions is reduced. In this manner, according to the present invention, the dose amount of the implanted carbon ions can be reduced compared with conventional methods while maintaining the crystallinity of the formed silicon carbide layer; therefore, manufacturing cost can be reduced compared with the conventional methods, and manufacturing time can be shortened since implantation time can be shortened. Therefore, according to the present invention, productivity of SiC wafers can be improved without deteriorating the crystallinity of the silicon carbide layers.

Moreover, according to the present invention, the maximum value of the carbon concentration in the silicon substrate is equal to or more than 20 % and equal to or less than 49 % in the carbon ion implantation; therefore, the above described effects can be reliably exerted.

Moreover, according to the present invention, the thickness of the formed buffer layer, especially in case of silicon oxide, is preferably equal to or more than 200 nm and equal to or less than 600 nm, and the carbon ion implantation is preferably carried out under the implantation conditions of the acceleration energy at equal to or more than 100 keV and equal to or less than 200 keV and the dose amount of equal to or more than 2.5×10¹⁷/cm² and equal to or less than 6×10¹⁷/cm²; therefore, the above described effects can be more reliably exerted.

Furthermore, according to the present invention, the carbon ion implantation is preferably carried out in the state that the silicon substrate is heated to a temperature that is equal to or more than 400 °C and equal to or less than 1000 °C; therefore, the above described effects can be more reliably exerted.

Hereinafter, embodiments of the present invention will be described in detail with reference to drawings.

### Brief Explanation of the Figures

Fig. 1 is a process drawing exemplary showing a series of processes in a manufacturing method of a silicon carbide layer according to a first embodiment of the present invention.
Fig. 2 is a flow chart corresponding to Fig. 1.
Fig. 3 is a process drawing exemplary showing a series of processes in a manufacturing method of a silicon carbide layer according to a second embodiment of the present invention.
Fig. 4 is a flow chart corresponding to Fig. 3.
Fig. 5 is a flow chart exemplary showing a series of processes in a conventional manufacturing method.

### Explanation of Reference Numerals

- 1: Silicon Substrate
- 2: Silicon Oxide Layer
- 3: Carbon Containing Layer
- 4: Single-Crystal Silicon Carbide Layer
- 5: Oxide Layer
- 10: SiC Wafer

### First Embodiment

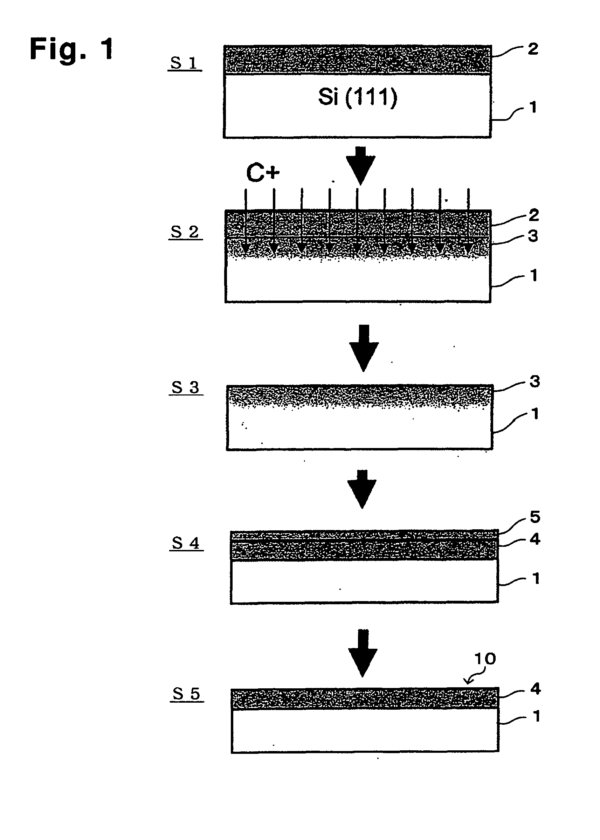

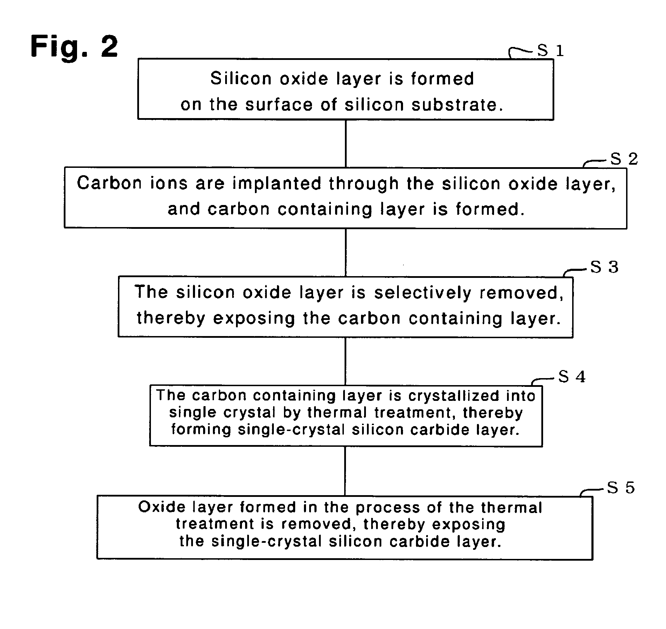

Fig. 1 is a process drawing exemplary showing a series of processes in a manufacturing method of a silicon carbide layer according to a first embodiment of the present invention, and Fig. 2 is a flow chart corresponding to Fig. 1.

This manufacturing method manufactures a SiC wafer 10 by sequentially carrying out:
step S1 of forming a silicon oxide layer 2 on the surface of a silicon substrate 1,
step S2 of implanting carbon ions into the silicon substrate 1 through the silicon oxide layer 2, thereby forming a carbon containing layer 3 in which silicon and carbon are mixed,
step S3 of selectively removing the silicon oxide layer 2 from the silicon substrate 1, thereby exposing the carbon containing layer 3,
step S4 of subjecting the silicon substrate 1 to thermal treatment and crystallizing the carbon containing layer 3 into a single crystal, thereby forming a single-crystal silicon carbide layer 4, and
step S5 of removing an oxide layer 5, which is formed on the surface of the single-crystal silicon carbide layer 4 in the process of the thermal treatment, thereby exposing the single-crystal silicon carbide layer 4.

In step S1, the silicon oxide layer 2 comprised of silicon oxide (SiO₂) is formed at a surface part of the silicon substrate 1. The silicon oxide layer 2 is formed, for example, by subjecting the silicon substrate 1 to dry oxidation or wet oxidation at about 1000 °C. Alternatively, the silicon oxide layer 2 is formed on the silicon substrate 1 by using the chemical vapor deposition method (CVD) or is formed by the combination of dry oxidation/wet oxidation and CVD. In step S1, instead of the silicon oxide layer 2, a buffer layer comprised of a silicon nitride (Si₃N₄, SiN) or a combination with a silicon oxide may be formed. Alternatively, a buffer layer that can be selectively removed from the silicon substrate 1 can be formed by another solid material having thermal resistance equivalent to that of the silicon oxide or silicon nitride. The thickness of the silicon oxide layer 2 or any other buffer layer is preferably selected from the values in the range of equal to or more than 200 nm to equal to or less than 600 nm. Note that the silicon substrate 1 is formed, for example, from a silicon single-crystal ingot manufactured by the Czochralski method or float zone method.

In step S2, the implantation conditions of the carbon ions are adjusted to carry out carbon ion implantation so that the maximum value of the carbon concentration in the silicon substrate 1 is equal to or more than 20 % and equal to or less than 49 %. The carbon containing layer 3 immediately below the silicon oxide layer 2 immediately after carbon ion implantation comprises single-crystal silicon carbide grains.

It is significantly important to cause the maximum value of the carbon concentration in the carbon containing layer 3 to be equal to or more than 20 % in order to maintain crystallinity of the single-crystal silicon carbide layer 4. If the maximum value of the carbon concentration in the carbon containing layer 3 is less than 20 %, defects of fine carbon grains occur in the single-crystal silicon carbide layer 4 after annealing, thereby deteriorating crystallinity of the single-crystal silicon carbide layer 4. Meanwhile, when the maximum value of the carbon concentration in the carbon containing layer 3 is equal to or more than 20 %, appearance of the above described carbon grains can be suppressed.

The carbon ion implantation is preferably carried out under the implantation conditions that the acceleration energy (implantation energy) of the carbon ions is equal to or more than 100 keV and equal to or less than 200 keV and that the dose amount (implantation amount) of the carbon ions is equal to or more than 2.5×10¹⁷/cm² and equal to or less than 6×10¹⁷/cm². Note that the implantation conditions of the carbon ions are adjusted by adjusting the acceleration energy of the carbon ions and the dose amount of the carbon ions in accordance with the thickness of the silicon oxide layer 2.

The carbon ion implantation is desirably carried out in the state in which the silicon substrate is heated to a temperature equal to or more than 400 °C. When the heating temperature of the substrate is lower than 400 °C, the orientation of the single-crystal silicon carbide grains constituting the carbon containing layer 3 is disturbed after the implantation; therefore, after the annealing, crystallinity of the single-crystal silicon carbide layer 4 is impaired, and, sometimes in extreme cases, it becomes a polycrystalline layer or an amorphous layer.

More preferably, in order to further enhance the crystallinity of the single-crystal silicon carbide layer 4, the carbon ion implantation is desirably carried out in the state in which the silicon substrate is heated to a temperature that is equal to or more than 500 °C.

The carbon ion implantation is desirably carried out in the state in which the silicon substrate is heated to a temperature that is equal to or less than 1000 °C. If the heating temperature of the substrate exceeds 1000 °C, the single-crystal silicon carbide grains constituting the carbon containing layer 3 are fused like dendrites after the implantation, and, after the annealing, the denseness and uniformity of the single-crystal silicon carbide layer 4 is impaired.

More preferably, in order to further enhance the denseness and uniformity of the single-crystal silicon carbide layer 4, the carbon ion implantation is desirably carried out in the state in which the silicon substrate is heated to a temperature that is equal to or less than 800 °C.

Note that the above described ion implantation conditions are adjusted by adjusting the implantation energy of the carbon ions and the dose amount of the carbon ions in accordance with the thickness of the silicon oxide layer 2.

In step S3, the silicon oxide layer 2 is subjected to liquid phase etching, thereby selectively removing merely the silicon oxide layer 2. In the removal of the silicon oxide layer 2, for example, a dilute hydrofluoric acid or ammonium fluoride can be utilized as a liquid phase etchant. When the buffer layer comprised of a nitride is used instead of the silicon oxide layer 2, a hot phosphoric acid or the like can be utilized as a liquid phase etchant.

In step S4, the silicon substrate 1 is subjected to thermal treatment in an argon gas atmosphere containing about 0.5 vol.% of oxygen at a temperature that is equal to or more than 1100 °C and less than the melting point of silicon. The time required for the thermal treatment is about 10 hours. The thermal treatment in step S4 is carried out desirably at equal to or more than 1200 °C and more desirably at equal to or more than 1300 °C within the temperature range that is less than the melting point of silicon. In the process of crystallization of the carbon containing layer 3 into a single crystal, oxides in the carbon containing layer 3 move to the surface; therefore, the oxygen content in the finally-formed single-crystal silicon carbide layer 4 is extremely small.

In step S5, the oxide layer 5 is removed by etching by a dilute hydrofluoric acid, thereby exposing the single-crystal silicon carbide layer 4. When the oxide layer 5 is removed, the oxides carried from the carbon containing layer 3 to the surface are completely removed in the state that they are taken in the oxide layer 5.

In steps S3 and S5, gas phase etching can be carried out instead of liquid phase etching.

As described above, in the manufacturing method of the silicon carbide layer according to the first embodiment of the present invention, the dose amount of the implanted carbon ions can be caused to be equal to or more than 2.5×10¹⁷/cm² and equal to or less than 6×10¹⁷/cm², and the dose amount of the carbon ions can be significantly reduced compared to the conventional dose amount (6.5×10¹⁷ to 8.0×10¹⁷ /cm²) for achieving stoichiometry.

Note that the thermal treatment of step S4 may be carried out in a non-oxidizing atmosphere. In this case, step S5 can be omitted, and the single-crystal silicon carbide layer 4 is exposed on the surface immediately after the annealing.

### Second Embodiment

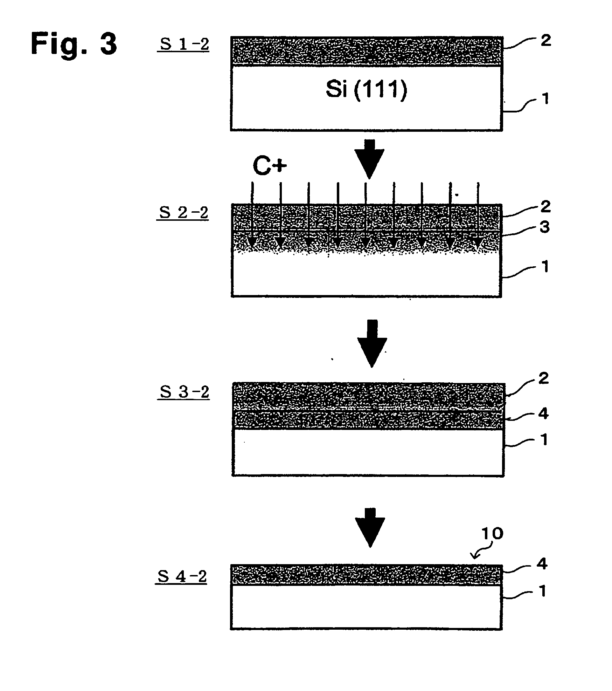

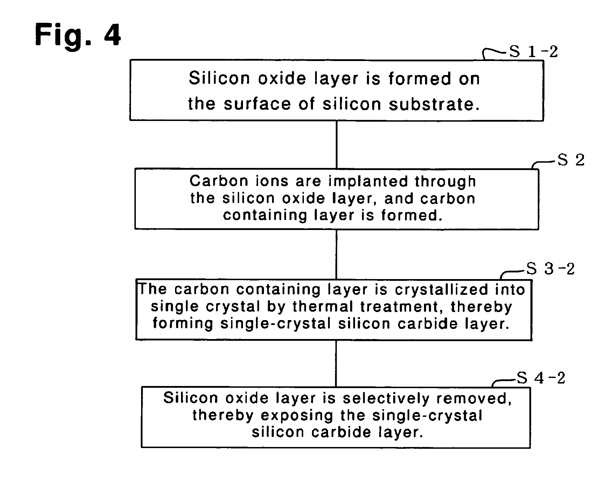

Fig. 3 is a process drawing exemplary showing a series of processes in a manufacturing method of a silicon carbide layer according to a second embodiment of the present invention, and Fig. 4 is a flow chart corresponding to Fig. 3.

This manufacturing method manufactures a SiC wafer 10 by sequentially carrying out:
step S1-2 of forming a silicon oxide layer 2 on the surface of a silicon substrate 1,
step S2-2 of implanting carbon ions into the silicon substrate 1 through the silicon oxide layer 2, thereby forming a carbon containing layer 3 in which silicon and carbon are mixed,
step S3-2 of subjecting the silicon substrate 1 to thermal treatment and crystallizing the carbon containing layer 3 into a single crystal, thereby forming a single-crystal silicon carbide layer 4, and
step S4-2 of selectively removing the silicon oxide layer 2 from the silicon substrate 1, thereby exposing the single-crystal silicon carbide layer 4.

Among above described steps S1-2 to S4-2, S1-2 and S2-2 are same as steps S1 and S2 of the first embodiment.

In step S3-2, the silicon substrate 1 is subjected to the thermal treatment in an argon gas atmosphere containing about 0.5 vol.% of oxygen at a temperature equal to or more than 1100 °C and less than the melting point of silicon. The time required for this thermal treatment is about 10 hours. The thermal treatment may be carried out at a temperature equal to or more than 1200 °C or a temperature equal to or more than 1300 °C within the temperature range that is less than the melting point of silicon. In the process that the carbon containing layer 3 is crystallized into a single crystal, oxygen in the carbon containing layer 3 moves into the silicon oxide layer 2; therefore, the oxygen content in the finally-formed single-crystal silicon carbide layer 4 is extremely small.

In step S4-2, the silicon oxide layer 2 is removed by etching by a dilute hydrofluoric acid, thereby exposing the single-crystal silicon carbide layer 4. When the silicon oxide layer 2 is removed, the oxygen carried out from the carbon containing layer 3 is completely removed in the state that the oxygen is taken in the silicon oxide layer 2. In step S4-2, gas phase etching may be carried out instead of liquid phase etching.

As described above, according to the manufacturing method according to the second embodiment of the present invention, the dose amount of the carbon ions can be significantly reduced compared with the conventional amount, as well as the manufacturing method according to the above described first embodiment.

### Examples

Hereinafter, the present invention will be described in more detail by way of examples; however, the present invention is not limited thereto.

### First Example

A plurality of (111) n-type float-zone silicon wafers, each of which having a diameter of 150 mm, were prepared and subjected to thermal treatment in a dry oxidizing atmosphere at 1100 °C, thereby forming a silicon oxide layer comprised of a surface oxide film having a thickness of 400 nm on each of the wafers. The wafers were subjected to implantation of carbon ions (C+) at a wafer heating temperature of 550 °C, at acceleration energy of 180 keV, and with dose amounts of 2.0×10¹⁷/cm², 2.5×10¹⁷/cm², 5.0×10¹⁷/cm², 6.0×10¹⁷/cm², and 7.5×10¹⁷/cm², respectively, thereby forming a carbon containing layer in each of the silicon substrates. After the carbon ion implantation, the cross sectional structures of the vicinities of the surfaces of part of the samples were evaluated by a cross-section transmission electron microscope (cross-section TEM). As a result of the cross-section TEM, it was confirmed that in the entirety of the samples, an amorphous silicon region formed above the carbon containing layer was contained in the silicon oxide layer. Regarding the rest of the samples, after the carbon ion implantation, the silicon oxide layer formed on each of the samples was removed by a dilute hydrofluoric acid. Subsequently, each of the samples was subjected to high-temperature annealing at 1350 °C in an Ar atmosphere with 0.5 vol.% of O₂ for 10 hours by a vertical high-temperature thermal treatment furnace, and a surface oxide film formed on the sample surface was then removed by a dilute hydrofluoric acid. Then, the crystal quality of the samples was evaluated by the Secco etching method. In the sample with the dose amount of 2.0×10¹⁷/cm², the single-crystal silicon carbide layer was lost upon the Secco etching due to a large amount of crystal defects. However, in the samples with the dose amounts of equal to or more than 2.5×10¹⁷/cm², the single-crystal silicon carbide layers were not lost, crystal defects were not found.

### First Comparative Example

A plurality of (111) n-type float-zone silicon wafers, each of which having a diameter of 150 mm, were prepared. Without forming silicon oxide layers on the wafers, the wafers were subjected to implantation of carbon ions (C+) at a wafer heating temperature of 550 °C, at acceleration energy of 180 keV, and with dose amounts of 5.0×10¹⁷/cm², 6.0×10¹⁷/cm², and 7.5×10¹⁷/cm², respectively, thereby forming a carbon containing layer in each of the silicon substrates. Subsequently, each of the samples was subjected to high-temperature annealing at 1350 °C in an Ar atmosphere with 0.5 vol.% of O₂ for 10 hours by a vertical high-temperature thermal treatment furnace. Subsequently, a surface oxide film, a silicon layer, and a transition layer were oxidized in a dry oxidizing atmosphere at 1100°C, and a surface oxide film formed on the surface of each sample by this oxidation was removed by a dilute hydrofluoric acid. Then, the crystal quality of the samples was evaluated by the Secco etching method. In each of the samples with the dose amounts of equal to or less than 6.0×10¹⁷/cm², it was confirmed that the single-crystal silicon carbide layer was lost upon the Secco etching due to a large amount of crystal defects and that a normal single-crystal silicon carbide film was not formed.

### Second Example

A (111) n-type Czochralski silicon wafer having a diameter of 150 mm was prepared and subjected to thermal treatment in a dry oxidizing atmosphere at 1100 °C, thereby forming a silicon oxide layer comprised of a surface oxide film having a thickness of 400 nm on the wafer. The wafer was subjected to implantation of carbon ions (C+) at a wafer heating temperature of 550 °C, at acceleration energy of 180 keV, and with a dose amount of 5.0×10¹⁷/cm², thereby forming a carbon containing layer in the silicon substrate. Subsequently, a silicon oxide layer formed on the sample was removed by a dilute hydrofluoric acid. Subsequently, the sample was subjected to high-temperature annealing at 1350 °C in an Ar atmosphere with 0.5 vol.% of O₂ for 10 hours by a vertical high-temperature thermal treatment furnace. Then, a surface oxide film formed on the surface of the sample is removed by a dilute hydrofluoric acid. Then, the crystal quality of the sample was evaluated by the Secco etching method. A single-crystal silicon carbide layer was not lost, and crystal defects were not found in the sample.

### Second Comparative Example

A (111) n-type float-zone silicon wafer and an n-type Czochralski silicon wafer, each of which having a diameter of 150 mm, were prepared. Without forming a silicon oxide layer, each of these wafers was subjected to implantation of carbon ions (C+) at a wafer heating temperature of 550 °C, at acceleration energy of 180 keV, and with a dose amount of 7.5×10¹⁷/cm², thereby forming a carbon containing layer in the silicon substrate. Subsequently, each of the samples was subjected to high-temperature annealing at 1350 °C in an Ar atmosphere with 0.5 vol.% of O₂ for 10 hours by a vertical high-temperature thermal treatment furnace. Subsequently, a surface oxide film, a silicon layer, and a transition layer were oxidized in a dry oxidizing atmosphere at 1100 °C, and a surface oxide film formed on the surface of the sample by the oxidation was removed by a dilute hydrofluoric acid. Then, the crystal quality of each of the samples was evaluated by the Secco etching method. In the sample made from the float-zone silicon wafer, the single-crystal silicon carbide layer was not lost, and crystal defects were not found; however, in the sample made from the Czochralski silicon wafer, about 10/cm² crystal defects were found.

### Third Example

A plurality of (111) n-type float-zone silicon wafers, each of which having a diameter of 150 mm, were prepared and subjected to thermal treatment in a dry oxidizing atmosphere at 1100 °C, thereby forming silicon oxide layers comprised of surface oxide films having thicknesses of 150 nm, 200 nm, and 250 nm, respectively, on the wafers. Each of the wafers was subjected to implantation of carbon ions (C+) at a wafer heating temperature of 550 °C, at acceleration energy of 100 keV, and with a dose amount of 4.5×10¹⁷/cm², thereby forming a carbon containing layer in the silicon substrate. Subsequently, a silicon oxide layer formed on each of the samples was removed by a dilute hydrofluoric acid. Subsequently, each of the samples was subjected to high-temperature annealing at 1350 °C in an Ar atmosphere with 0.5 vol.% of O₂ for 10 hours by a vertical high-temperature thermal treatment furnace, and then, a surface oxide film formed on the surface of the sample was removed by a dilute hydrofluoric acid. Then, the crystal quality of the samples was evaluated by the Secco etching method. In the sample having the surface oxide film having the thickness of 150 nm, the single-crystal silicon carbide layer was lost upon the Secco etching due to a large amount of crystal defects; however, in the samples having the surface oxide films having the thicknesses of equal to or more than 200 nm, the single-crystal silicon carbide layers were not lost, and crystal defects were not found.

### Fourth Example

A plurality of (111) n-type float-zone silicon wafers, each of which having a diameter of 150 mm, were prepared and subjected to thermal treatment in a dry oxidizing atmosphere at 1100 °C, thereby forming silicon oxide layers comprised of surface oxide films having thicknesses of 550 nm, 600 nm, and 650 nm, respectively, on the wafers. Each of the wafers was subjected to implantation of carbon ions (C+) at a wafer heating temperature of 550 °C, at acceleration energy of 200 keV, and a dose amount of 4.5×10¹⁷/cm², thereby forming a carbon containing layer in the silicon substrate. Subsequently, a silicon oxide layer formed on each of the samples was removed by a dilute hydrofluoric acid. Subsequently, each of the samples was subjected to high-temperature annealing at 1350°C in an Ar atmosphere with 0.5 vol.% of O₂ for 10 hours by a vertical high-temperature thermal treatment furnace, and then, a surface oxide film formed on the surface of the sample was removed by a dilute hydrofluoric acid. Then, the crystal quality of the samples was evaluated by the Secco etching method. In the sample having the surface oxide film having the thickness of 650 nm, the single-crystal silicon carbide layer was lost upon the Secco etching due to a large amount of crystal defects; however, in the samples having the surface oxide films having thicknesses of equal to or less than 600 nm, the single-crystal silicon carbide layers were not lost, and crystal defects were not found.

As described above, according to the present invention, the crystallinity of the formed silicon carbide layer can be maintained even when the dose amount of the carbon ions is equal to or more than 2.5×10¹⁷ cm² and equal to or less than 6×10¹⁷ cm² that is smaller than the stoichiometric amount (6.5×10¹⁷ to 8.0×10¹⁷ cm²). Therefore, according to the present invention, the dose amount of the implanted carbon ions can be reduced compared to conventional amounts while maintaining the crystallinity of the formed silicon carbide layer. Thus, compared with conventional methods, manufacturing cost can be reduced, and manufacturing time can be shortened since implantation time can be shortened. Therefore, according to the present invention, productivity of SiC wafers can be improved without deteriorating the crystallinity of the silicon carbide layers.

## Claims

1. A method for manufacturing silicon carbide, comprising a step of forming a buffer layer on a surface of a silicon substrate, a step of implanting carbon ions into the silicon substrate through the buffer layer so as to form a carbon containing layer in the silicon substrate, a step of selectively removing the buffer layer from the silicon substrate so as to expose the carbon containing layer, and a step of subjecting the silicon substrate to thermal treatment so as to form a crystalline silicon carbide layer; wherein upon the carbon ion implantation, the carbon containing layer is formed immediately below the buffer layer and the maximum value of the carbon concentration in the silicon substrate is equal to or more than 20 % and equal to and less than 49 %.

2. A method for manufacturing silicon carbide, comprising a step of forming a buffer layer on a surface of a silicon substrate, a step of implanting carbon ions into the silicon substrate through the buffer layer so as to form a carbon containing layer in the silicon substrate, a step of subjecting the silicon substrate to thermal treatment so as to form a crystalline silicon carbide layer, and a step of selectively removing the buffer layer from the silicon substrate so as to expose the crystalline silicon carbide layer; wherein upon the carbon ion implantation, the carbon containing layer is formed immediately below the buffer layer and the maximum value of the carbon concentration in the silicon substrate is equal to or more than 20 % and equal to and less than 49 %.

3. The method according to any one of claims 1 to 2, wherein the buffer layer consists of silicon oxide or silicon nitride or a mixture thereof.

4. The method according to any on of claims 1 to 3, wherein the thickness of the buffer layer is equal to or more than 200 nm and equal to or less than 600 nm.

5. The method according to any one of claims 1 to 4, wherein the carbon ion implantation is carried out under the implantation condition of an acceleration energy of equal to or more than 100 keV and equal to or less than 200 keV.

6. The method according to any one of claims 1 to 5, wherein the carbon ion implantation is carried out under the implantation condition of a dose amount of equal to or more than 2.5×10¹⁷/cm² and equal to or less than 6×10¹⁷/cm².

7. The method according to any one of claims 1 to 6, wherein the carbon ion implantation is carried out in the state that the silicon substrate is heated to a temperature of equal to or more than 400 °C and equal to or less than 1000 °C.

8. The method according to any one of claims 1 to 7, wherein the carbon containing layer immediately below the buffer layer immediately after the carbon ion implantation comprises single-crystal silicon carbide grains.

9. The method according to any one of claims 1 to 8, wherein the silicon substrate is a silicon substrate manufactured by either a Czochralski method or a float zone method.
